# EUROPEAN PATENT SPECIFICATION

(11) **EP 1 166 608 B1**
(45) Date of publication and mention of the grant of the patent: **28.05.2003**
(21) Application number: 00918810.3
(22) Date of filing: 17.03.2000
(51) Int. Cl.: H05K 7/20, G06F 1/20

(54) **CASING WITH A FAN UNIT AND FAN UNIT**
GEHÄUSE MIT EINER LÜFTEREINHEIT UND LÜFTEREINHEIT
BOITIER AVEC UNITE DE VENTILATION ET UNITE DE VENTILATION

(30) Priority: 18.03.1999 DE 29904928 U; 11.11.1999 US 438175
(43) Date of publication of application: 02.01.2002
(73) Proprietor: Fritschle, Simone, 70195 Stuttgart (DE)
(72) Inventor: FRITSCHLE, Claus, D-70195 Stuttgart (DE); HEESEN, Klaus, D-70195 Stuttgart (DE)
(74) Representative: Lindner, Michael, Dipl.-Ing.
(86) International application number: EP0002391
(87) International publication number: WO00057682

(56) References cited:
- US-A- 5 210 680
- US-A- 5 788 467
- US-A- 5 876 278
- PATENT ABSTRACTS OF JAPAN vol. 1995, no. 09, 31 October 1995 (1995-10-31) -& JP 07 162180 A (FUJITSU LTD), 23 June 1995 (1995-06-23)
- PATENT ABSTRACTS OF JAPAN vol. 017, no. 706 (E-1483), 22 December 1993 (1993-12-22) -& JP 05 243772 A (FUJITSU LTD), 21 September 1993 (1993-09-21)

## Description

### FIELD OF APPLICATION AND PRIOR ART

The invention relates to a casing for an electrical device, particularly an electronic device or a computer, having a fan unit for producing an air flow in at least a part of the casing.

Normally heat builds up in electrical or electronic devices such as computers, as a result of components thereof and must be dissipated in order to avoid overheating. In particular, computer processors must be cooled in order to avoid malfunctions or damage. It is known to fit a fan unit to a casing of the aforementioned type, generally to its rear wall, the fan unit being directed into the casing. As such fan units are generally internally screwed to the casing, replacement is only possible with considerably difficulty. Such a fan unit is for example disclosed in US 5,788,467. The fan unit shown in this document is adapted to be detachably inserted and mounted into a cabinet for an electronic device accommodating a plurality of electronic circuit units, for forcibly air-cooling the interior of the cabinet.

A further disadvantage of known casings is that side or top walls must be unscrewed for getting entrance into the interior of the casing, for example for maintenance work.

### PROBLEM AND SOLUTION

The problem of the invention is to provide a casing with a fan unit according to the preamble of claim 1, in which the fitting of the fan unit is improved and access to the interior of the casing is made easier.

This problem is solved by the features of claim 1. A fan unit insertable from the outside and secured in a casing recess within the casing or device can be easily and rapidly replaced, particularly without it being necessary to open or remove the entire casing. Since the top is only removable with said fan unit take out, access to the interior of the casing may be achieved simply by taking off the top without having to loosen any screws.

The inserted fan unit can at least substantially and in particular completely project into the casing or device. The fan unit can be located in a recess or a free space within the casing. The distance from further device components contained in the casing can differ as a function of the fan unit used and can in particular be very small.

Preferably the fan unit has at least one electromotive fan and preferably several fans. Several fans can be arranged in a group or at least two fans can be axially juxtaposed. In certain circumstances the fan unit can be detachably secured in the casing in a very simple manner. In the case of insertion from above into the casing, one possibility consists of a mounting support with stop action substantially solely on the basis of the weight of the fan unit. The fan unit is preferably lockable by a nonpositive connection, particularly by locking means. On inserting the fan unit into the casing said locking means can be automatically activated, particularly at the end of the insertion path.

Advantageously there is a locking nose on the casing and a corresponding locking receptacle on the fan unit, particularly in order to simplify a replacement of a defective locking receptacle on the accessible fan unit.
The fan unit is preferably detachable from the casing and is preferably completely detachable or separable. For the electrical supply of the fan unit it is possible to provide a plug connection in the casing and on the fan unit. Advantageously there is a plug coupling, particularly with contacts over which project an envelope, in the casing and a plug on the fan unit. According to an embodiment the plug connection can be positioned laterally in the casing, preferably on a lateral face. It can in particular be substantially located at the beginning of an insertion path for the fan unit, in order for better centering of the plug connection. Preferably the plug coupling in the casing has some room to move for easier insertion of the plug on the fan unit. A plug connection can form part of the locking means for fixing the fan unit. It is also possible to construct a plug connection as part of guidance means for a positionally correct mounting of the fan unit in the casing.

In the vicinity of the recess the casing can have a guide device for the fan unit on insertion into the casing. The guide can be a system of guide rails and guide receptacles, the guide rails preferably being on the fan unit, e.g. in the form of elongated projections. Advantageously the lateral edge of the fan unit, particularly a fan or its casing, can be part of the guide rails, the casing being provided on the inside with a corresponding, preferably U-shaped guide receptacle.

The fan unit, particularly also the recess, can advantageously extend over a significant part of at least one extension direction of the casing and
preferably perpendicular both to the insertion direction and also to the axial direction of the fan or the air flow produced. In this way an air flow can be produced, which moves substantially through the entire casing or its cross-section. The fan unit can in particular extend over a plane perpendicular to the axial direction and takes up a main part of cross-section. It preferably takes up about 80% of the width and about the same of the height. It is possible to install at least one separate channel in the casing running in its longitudinal direction. In one such channel under the fan unit a power unit or several power units can be accommodated. Such a channel can take up less than the entire length of the casing, for example start near the fan unit. The channel in this case can advantageously be made up of a sheet material with special characteristics regarding EMR (electromagnetic restistability) requirements. In this way it is possible to protect the rest of the casing from the electromagnetic radiation of the power unit. The power unit can be provided with its own ventilation, especially an in-built air fan. A preferred place for a power unit is near or on the back side of the casing.

The aeration for the casing and for the power unit can be partly together along the same path. Especially an aeration stream can enter the casing on the front side, then be parted and run on one hand through the fan unit and on the other hand enter the separate channel under the fan unit with the power unit. So the aeration stream is drawn in together by the fan unit and the in-built air fan of the power unit, wherein it is blown through separately.

On at least one side of the fan unit a further channel can be provided in the casing. This channel preferably is a cable channel with electrical cables running through it. Such cables could be connector cables for disk drives or the like as well as power cables, for example for the fan unit. In such a channel the cables can be securely and orderly mounted and packed, and with such a separate channel there is no risk of injuring a cable. Preferably the cables are multi-cord cables. In one embodiment such multi-cord cables are originally flat connector cables with the single cords being separated after fixing the plug connection to its ends. Such a cable can be easily wound around corners or through small holes.

When the fan unit is inserted the recess in the casing can be at least partly and in particular completely sealed in the insertion area, so that a casing with inserted fan unit appears sealed from the outside.

The casing is advantageously substantially parallelepipedic, particularly flat and elongated in one direction. Along the elongated extension the recess can be located roughly centrally in the casing, advantageously in the area where most of the heat is evolved. Preferably the casing has a front panel and the fan unit air flow runs substantially from said front panel to the opposite back of the casing. In particularly preferred manner, at least on the back and in particular also on the front, there are air openings, preferably also on other lateral faces of the casing, especially in areas with the greatest heat evolution of the device.

According to an embodiment the casing can be a casing module of a computer, particularly a so-called 19" slide-in module for a larger computer, e.g. a medium-sized to large computer. Such computers can comprise several casing modules of the aforementioned type with different dimensions, particularly with regards to the height. Preferably a casing module of the presently described type has data carrier or disk drives and/or processors, which in particular have a high, lasting cooling air requirement.

The fan unit can be placed e.g. roughly in the middle of the longitudinal direction of the casing. Clearly, the chosen location of the fan unit will depend on the arrangement of the computer units and parts in the casing. Cooling air can be drawn in through the front side, especially through ventilation openings in the form of slits or the like, and run through the casing. Behind the fan the air is being blown through the back part of the casing, leaving the casing through ventilation openings on the lateral sides and on the back side. In the front part of the casing can be mounted components such as disk drives or the like. In the back part processors and electronic circuit boards can be mounted for better ventilation by blowing air at them.

The casing can have a lockable hinged front shutter, after opening of which the front part of the server in the casing is accessible. Furthermore, such a lock could also be used to secure the fan unit in the casing or lock the whole modular casing against being opened.

The casing or the electrical device in the casing can have several power units, either for more power or for a safe supply. These power units are all connected together to a common busbar, to which the single components like disk drives or the like can be connected. Preferably such a busbar has several plug connections mounted to it, to which can be fitted appropriate plug connections of the components. In this way the change of a component in the casing is very simple, as there need only plug connections to be separated and connected.

It is also possible to create a fan unit for insertion in a casing for an electrical device which, according to the invention, has at least one fan located on a support or the like, with which it can be inserted and retained or locked at least to a very significant extent in a corresponding recess in the casing. On the one hand when the fan unit is inserted from above mounting can particularly easily take place and on the other a locking means can be provided. Advantageously the fan unit is constructed as a slide-in module for the casing. It is in particular mechanically and/or electrically detachable and preferably completely separable from the casing. In particularly preferred manner the fan unit is an independent assembly.

A fan unit can have several fans, which are arranged in a group or juxtaposed. They are preferably axially juxtaposed and in particular are connected directly to one another.

A fan can be detachably fitted to a support, particularly a flat support. Said support can simultaneously form or have a shield for sealing the recess of the casing to the outside.

The fan unit is advantageously detachably mountable in the casing in simple manner and is preferably locked by a nonpositive connection. For this locking means can be provided, particularly in the form of a locking receptacle, which corresponds to a locking nose located in the casing. A fitting of the locking receptacle to the removable fan unit offers the advantage that a defective locking receptacle can be easily replaced.

The at least one fan is preferably an axial flow fan with blades fitted to the rotor, particularly an external rotor of the fan motor. In particularly preferred manner use is made of direct current motors, particularly brushless d.c. motors, e.g. with an operating voltage of 12 V d.c. The operating voltage for the fans can be taken from a power supply unit of the associated casing, e.g. by means of plug contacts closing on inserting the fan unit and located on the latter and the casing.

These and further features can be gathered from the claims, description and drawings and the individual features, either singly or in the form of subcombinations, can be implemented in an embodiment of the invention and in other fields and can represent advantageous, independently protectable constructions for which protection is hereby claimed. The subdivision of the application into individual sections and the subtitles in no way restrict the general validity of the statements made thereunder.

### BRIEF DESCRIPTION OF THE DRAWINGS

An embodiment of the invention is explained hereinafter relative to the attached drawings, wherein show:
- Fig. 1: An inclined view of a fan unit with three juxtaposed axial flow fans.
- Fig. 2: A casing module with a central recess for a fan unit according to fig. 1.
- Fig. 3: A schematic view of a longitudinal cross section of the casing with the fan unit inserted and the channels on its sides.
- Fig. 4: A schematic view of a lateral cross section of a server casing with the fan unit and the components as well as the cooling air stream.
- Fig. 5: A schematic view of the power units of the casing with a common Busbar, to which are connected components of the server.

### DETAILED DESCRIPTION OF THE EMBODIMENT

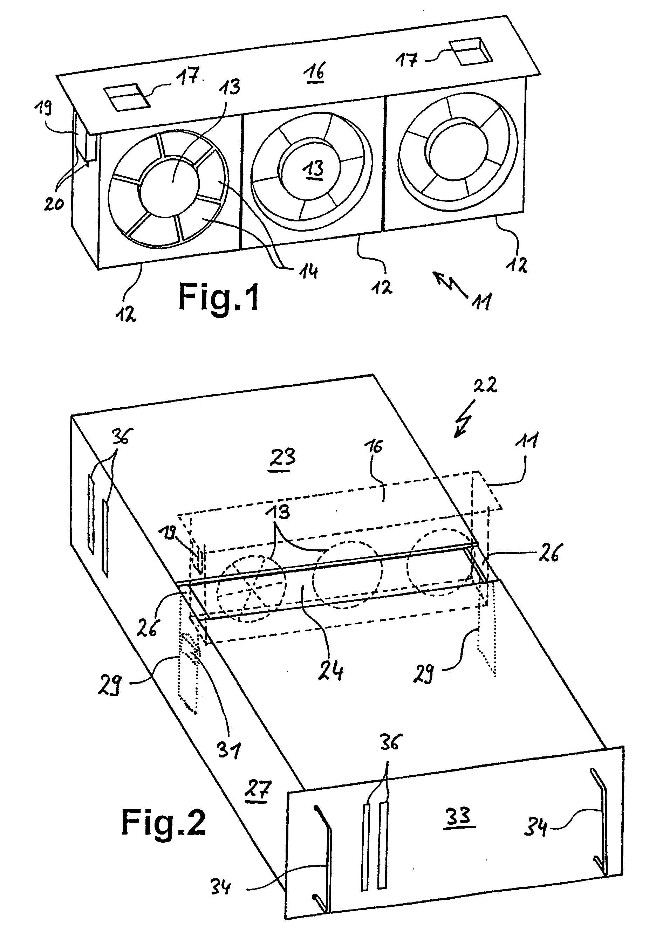

Fig. 1 shows a fan unit 11 having three juxtaposed fans 12. The fans 12 are constructed as axial flow fans with fan blades 14 fitted to the rotor 13 of a fan motor. With respect to the left-hand fan the blades 14 are solely shown in exemplified manner and are only diagrammatically represented for the two other fans. The three fans 12 form a type of fan field, in which they produce a wide, voluminous and preferably equidirectional air flow.

The fans 12 are connected by means of a not shown carrier or support to the underside of a cover shield 16, which projects over the same both as regards width and depth. To the left and right the shield 16 has two catches 17 by means of which the fan unit 11 is held and can if necessary be drawn out of a casing.

Laterally a connector 19 with two contact pins 20 is fitted to the left-hand fan 12 and the contact pins 20 can be connected to the fans 12 by means of not shown cables. The connector 19 can simultaneously form part of locking means, particularly a locking receptacle. The contact pins 20 can also form part of locking means, preferably locking pins or noses.

Fig. 2 shows a casing 22, which can be constructed in the form of a so-called 19" slide-in module for a computer, particularly a server. Roughly centrally on its top 23 the casing 22 has a recess 24, which extends virtually over the entire width of the casing. It is possible to see on the lateral edges of the recess 24 support profiles 26, which give the casing 22 stability and serve as a supporting means for a fan unit 11 or its cover shield represented in broken line form.

Guide receptacles 29 shown in dotted line form extend along the inside of the casing 22, particularly along the inner lateral faces 27 and serve to receive the fan unit 11. In particular, the guidance width thereof corresponds to the extension of the fan unit 11, which is guided in positionally secure manner between the guide receptacles 29. A plug coupling 31 is represented in dotted line form in the upper area of the left-hand guide receptacle 29. On or in said coupling can engage a connector of the fan unit 11 and form the electrical contact between the casing 22 or its power supply unit and the fan unit 11.
The casing 22 has a front panel 33 formed by a plate, which projects somewhat over the sides of the casing. The front panel 33 has both grips 34 for extracting the casing from a casing support and venting slots 36. It is also possible to provide operational units such as switches, displays, keyboards, etc., as well as insertion openings for data carriers or disks. Further venting slots 36 are e.g. provided on the rear, visible lateral face of the casing 22 and advantageously also on the not visible back, particularly substantially distributed over the same. With an air flow along the casing it is advantageous to provide ventilation possibilities at the corresponding casing ends. As a result of the fan unit 11 inserted in the casing 22 and which extends substantially over the entire casing cross-section, it is possible to pass through most and in particular all the devices located in the casing.

A replacement of the fan unit can take place by extraction using the catches 17, particularly also when the fan unit and/or device is in operation. The plug connection is released and following extraction the fan unit is completely separated from the casing 22. A different or a new, functional fan unit can be inserted in the opposite way. For insertion purposes, it is merely necessary to bring the fans 12 into the recess 24 and guide receptacle 29 and then completely slide or engage in the casing.

At the end of the insertion process the plug connection for the electrical contacting of the fans is automatically closed. An operation of the fans 12 can be controlled by the device or automatically started and also monitored. Monitoring permits the detection of a failure of one of the fans and a display or indication thereof.

The catches 17 in Fig. 1 could also be replaced by locks or lockable catches for locking the fan unit 11 in the casing 22. Preferably the cover shield 16 is constructed so as to overlap the front and the back part of the top 23, which can also be separated from the casing. For this it is only possible to remove the top parts 23 with the fan unit taken out. For example, the top parts on the front and the back of the casing 22 can be held under projections of the front end 33 and the back end of the casing. After removal of the fan unit 11 they can be pulled towards each other and be removed.

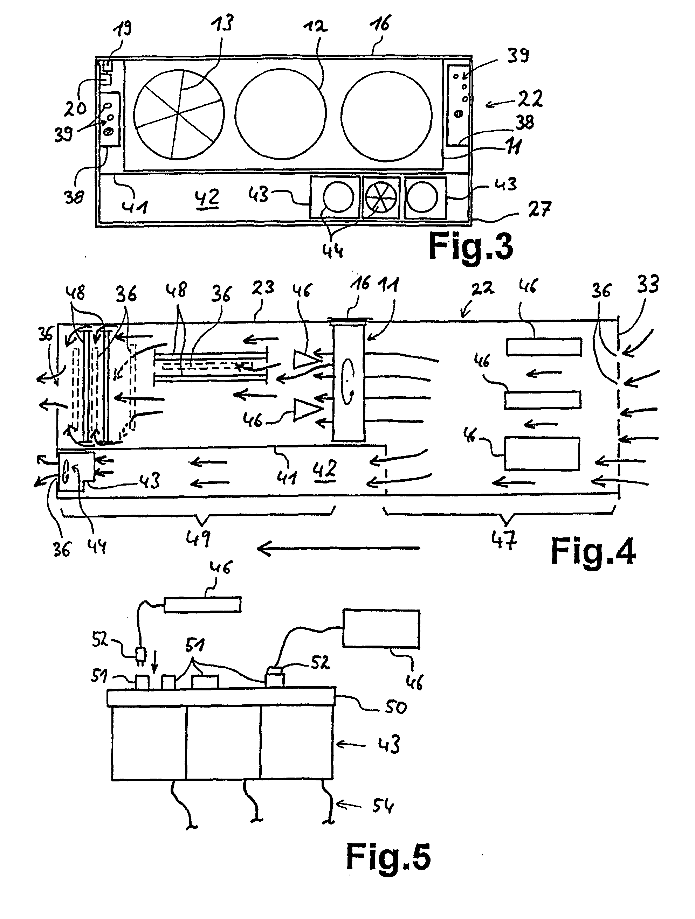

Fig. 3 shows a cross section of the casing 22 in a different embodiment compared to Figs. 1 and 2. The fan unit 11 has on its sides three channels provided in the casing. On the lateral sides are provided cable channels 38, being made up of sheet metal fixed to the inner sides of the casing 22. They can run at least over the area in which the fan unit 11 is inserted. The cable channels 38 contain several electrical cables 39. These cables 39 mainly are the electrical connections from components in front of the fan unit 11 to components behind the fan unit. The channels 38 can be partly open to insert new cables in it.

Beneath the fan unit 11 is mounted a cover 41 extending over the whole width of the casing 22. This cover 41 is provided for separating a further channel 42 from the rest of the inner of the casing 22. In the channel 42 three power units 43 are provided, which are mounted to the back side of the casing. The cover 41 is for protecting the rest of the casing and its components against the electromagnetic radiation from the power units 42. For this purpose the cover can be made up of advantageous materials like sheet metal combined with radiation screens. The power units 43 do have their own in-built air fans 44 for cooling purposes.

Fig. 4 mainly shows how the air stream is running through the casing 22. Through ventilating slots 36 in the front 33 air enters the casing being drawn in by the fans 12 of the fan unit 11 as well as by the in-built fans 44 of the power units. In the front part of the casing are mounted disk drives 46 such as hard disk drives, CD-ROM drives or the like. The air is being drawn through these towards the fans 12 and 44. This is the part 47 of air being drawn.
Before reaching the fan unit 11 the air stream is separated through the channel 42, a part of the air stream entering the channel. In the channel the air is being drawn towards the fans 44 of the power units 43. After streaming along the power units 43 the air is blown out of the casing through ventilating slots 36 on the back side.

The main air stream is running through the upper part of the casing 22, and is blown through the fan unit 11 in the back part. There deflector plates 46 are provided for directing the air flow in a desired direction. Mainly electronic circuit boards 48 are provided in the part 49 of the casing 22 where the air is being blown instead of being drawn. The circuit boards 48 are positioned in such a way that they do not totally block the path of the cooling air. Through ventilating slots 36 air that has been blown through two boards 48 close to each other can be directed outside. In this way a continuous air stream can be maintained even there. Some of the air leaves the casing 22 through slots 36 in the back side.

It can be clearly seen that the air stream running from the right to the left can often be divided and redirected, but the general direction is being maintained. By combining the air streams of the power units 43 with those of the fan unit 11 a stronger air stream and as such a better ventilation can be implemented.

Fig. 5 shows schematically how three power units 43 are connected to one single busbar 50, from which the components of an electrical device such as a server draw their electrical power. On the busbar are mounted several plug connectors 51, into which can be fitted appropriate plugs 52 of components such as the disk drives 46. The provision of plugs instead of other possibilities like soldering or screw connections is a much faster and easier connection. Through especially coded plug connections being characteristic for special kinds of components mistakes and wrong connections can be overcome. The power units 43 themselves are connected via connections 54 to a power source such as a mains connection in a server room.

For ecological reasons the casing 22 can be made up mainly of steel which is easily recyclable. No poisonous material is being used.

## Claims

1. Casing for an electronic device, said casing (22) having a fan unit (11) for producing an air flow in said casing (22), wherein:
- said casing (22) has a removable top (23) covering the topside of said casing (22),
- said fan unit (11) is insertable into said casing (22) from the outside through a recess (24) in said top and is lockable in said casing, and
- said top (23) being only removable with said fan unit taken out.

2. Casing according to claim 1, wherein in the inserted state of said fan unit (11) said fan unit largely projects into said casing (22).

3. Casing according to claim 2, wherein said fan unit (11) is located in a recess (24) in the casing interior.

4. Casing according to claim 1, wherein said fan unit (11) comprises at least one electromotive fan (12).

5. Casing according to claim 4, wherein said fan unit (11) comprises at least two fans (12) that are axially juxtaposed and parallel.

6. Casing according to claim 1, wherein said fan unit (11) can be detachably retained in said casing (22) and is locked by locking means (17).

7. Casing according to claim 6, wherein locking means are provided for said fan unit, said locking means comprising a locking nose on the casing (22) and a locking receptacle (29) on said fan unit (11).

8. Casing according to claim 1, wherein said fan unit (11) is detachable and completely separable from said casing (22), wherein further a plug connection (31) is provided in said casing for the electric power supply of said fan unit, said plug connection comprising a plug coupling (31) in the casing and a plug on the fan unit (11).

9. Casing according to claim 8, wherein said plug coupling (31) is positioned on one lateral face of said casing at the beginning of an insertion path of said fan unit (11).

10. Casing according to claim 9, wherein said plug coupling (31) in the casing (22) has some room to move for better insertion of said plug on said fan unit.

11. Casing according to claim 1, wherein said casing (22) in the vicinity of said recess (24) has a guide device for said fan unit for introduction into said casing, wherein said guide device comprises a system of guide rails fixed to said fan unit and guide receptacles (29) fixed to said casing.

12. Casing according to claim 11, wherein at least one single fan of said fan unit forms on the lateral edge of said fan unit said guide rails and on its inside said casing has said corresponding U-shaped guide receptacle.

13. Casing according to claim 1, wherein said fan unit (11) extends over a significant part of at least one extension direction of said casing perpendicular to the insertion direction and to the axial direction of said fan unit.

14. Casing according to claim 13, wherein said fan unit (11) extends over a plane perpendicular to the axial direction and takes more than half of the cross-section of said casing (22).

15. Casing according to claim 14, wherein beneath said fan unit (11) in said casing is a separate channel (38) being separately ventilated, wherein an EMR-protected power unit (43) is placed in said separate channel.

16. Casing according to claim 15, wherein said power unit (43) has its own fan unit, wherein both said fan units draw air from the front side of said casing (22) together.

17. Casing according to claim 13, wherein on at least one lateral side of said fan unit (11) in said casing runs a separated channel (42), in said channel several electrical connector cables are running, said cable channel being without ventilation.

18. Casing according to claim 1, wherein said fan unit (11) completely seals said recess in said casing in the insertion area.

19. Casing according to claim 1, wherein said casing (22) is substantially parallelepipedic, flat and elongated in one direction, said recess in the elongated extension being positioned roughly centrally in said casing.

20. Casing according to claim 1, wherein said fan unit (11) in a ventilation path through said casing is being positioned roughly centrally, with air being drawn in through the front end of said casing (22) and blown out through the back end of said casing.

21. Casing according to claim 20, wherein disk drives (46) are positioned in the area of air being drawn in by the said fan unit and processors and electronic circuit boards are positioned in the area of air being blown by said fan unit (11).

22. Casing according to claim 1, wherein said casing (22) comprises a front panel and the air flow of the fan unit flows substantially from said front panel to the opposite back of said casing, said back being provided with air openings as well as the back parts of the lateral edges of said casing are provided with aeration openings.

23. Casing according to claim 1, wherein an air flow through said casing (22) is being directed by aeration openings as well as deflecting or direction plates.

24. Casing according to claim 1, wherein said casing is a casing module of a 19" slide-in module for a medium sized to large computer, wherein data carriers and disk drives as well as processors being located in said casing module.

25. Casing according to claim 1, wherein said casing (22) comprises a lockable front shutter, wherein with said lockable front shutter said casing is totally lockable as well as said fan unit.

26. Casing according to claim 1, wherein the power supply of said casing comprises several single power supply stations being connected together with a main busbar, to said busbar plug connectors are being mounted for components like disk drives being mounted in said casing.

27. Fan unit for insertion in a casing (22) for an electronic device, wherein:
- said fan unit (11) comprises at least one fan (12) located on a support,
- said fan unit (11) with said support is at least largely insertable and lockable in a corresponding recess (24) within said casing,
- said fan unit has projections on said support,
- under said projections said fan unit (11) comprises locks for locking the fan unit (11) in the casing whereby the fan unit is undetachably locked by means of the inserted fan unit (11).

28. Fan unit according to claim 27, wherein said fan unit (11) is constructed as a slide-in module and is mechanically and electrically detachable from said casing, being completely separable from said casing forming an independent assembly.

29. Fan unit according to claim 27, wherein said fan unit comprises several fans (12) being juxtaposed and directly linked to one another, further being axially juxtaposed.

30. Fan unit according to claim 27, wherein said fan (12) is detachably fitted to said support, said support being flat for sealing said recess (24) of said casing (22).

31. Fan unit according to claim 27, wherein said fan unit (11) can be detachably retained in said casing (22) by locking means.

## Patentansprüche

1. Gehäuse für ein elektronisches Gerät, wobei das Gehäuse (22) eine Lüftereinheit (11) zur Erzeugung einer Luftströmung in dem Gehäuse (22) aufweist, wobei:
- das Gehäuse (22) einen entfernbaren Deckel (23) aufweist, der die Oberseite des Gehäuses (22) abdeckt,
- die Lüftereinheit (11) in das Gehäuse (22) von außen durch eine Aussparung (24) in dem Deckel einführbar und in dem Gehäuse verriegelbar ist, und
- der Deckel (23) nur entfernbar ist, wenn die Lüftereinheit herausgenommen ist.

2. Gehäuse nach Anspruch 1, wobei die Lüftereinheit im eingeführten Zustand in großem Umfang in das Gehäuse (22) hineinragt.

3. Gehäuse nach Anspruch 2, wobei die Lüftereinheit (11) in einer Aussparung (24) in dem Gehäuseinneren liegt.

4. Gehäuse nach Anspruch 1, wobei die Lüftereinheit (11) zumindest einen elektromotorischen Lüfter (12) aufweist.

5. Gehäuse nach Anspruch 4, wobei die Lüftereinheit (11) zumindest zwei Lüfter (12) aufweist, die axial nebeneinander und parallel liegen.

6. Gehäuse nach Anspruch 1, wobei die Lüftereinheit (11) lösbar in dem Gehäuse (22) gehalten werden kann und von einem Verriegelungsmittel (17) verriegelt wird.

7. Gehäuse nach Anspruch 6, wobei das Verriegelungsmittel für die Lüftereinheit vorgesehen ist, wobei das Verriegelungsmittel eine Verriegelungsnase an dem Gehäuse (22) und eine Verriegelungsaufnahme an der Lüftereinheit (11) aufweist.

8. Gehäuse nach Anspruch 1, wobei die Lüftereinheit (11) lösbar und vollständig trennbar von dem Gehäuse (22) ist, wobei ferner eine Steckverbindung (31) in dem Gehäuse für die elektrische Energieversorgung der Lüftereinheit vorgesehen ist, wobei die Steckverbindung eine Steckerkupplung (31) in dem Gehäuse und einen Stecker an der Lüftereinheit (11) aufweist.

9. Gehäuse nach Anspruch 8, wobei die Steckerkupplung (31) an einer seitlichen Fläche des Gehäuses am Anfang der Einführstrecke der Lüftereinheit (11) positioniert ist.

10. Gehäuse nach Anspruch 9, wobei die Steckerkupplung (31) in dem Gehäuse (22) Platz für eine Bewegung hat, um das Einstecken des Steckers der Lüftereinheit zu verbessern.

11. Gehäuse nach Anspruch 1, wobei das Gehäuse (22) in der Nähe der Aussparung (24) eine Führungseinrichtung für die Lüftereinheit zur Einführung in das Gehäuse aufweist, wobei die Führungseinrichtung ein System von Führungsschienen, die an der Lüftereinheit angebracht sind, und Führungsaufnahmen (29) aufweist, die an dem Gehäuse befestigt sind.

12. Gehäuse nach Anspruch 11, wobei zumindest ein einzelner Lüfter der Lüftereinheit an der seitlichen Kante der Lüftereinheit die Führungsschienen ausbildet, und das Gehäuse an ihrer Innenseite die entsprechende U-förmige Führungsaufnahme besitzt.

13. Gehäuse nach Anspruch 1, wobei die Lüftereinheit (11) sich über einen wesentlichen Teil von zumindest einer Erstreckungsrichtung des Gehäuses rechtwinklig zu der Einführungsrichtung und zu der axialen Richtung der Lüftereinheit erstreckt.

14. Gehäuse nach Anspruch 13, wobei die Lüftereinheit (11) sich über eine Ebene erstreckt, die rechtwinklig zu der axialen Richtung liegt und mehr als die Hälfte des Querschnitts des Gehäuses (22) einnimmt.

15. Gehäuse nach Anspruch 14, wobei unter der Lüftereinheit (11) in dem Gehäuse ein separater Kanal (38) vorgesehen ist, der separat belüftet wird, wobei eine EMR-geschützte Energieeinheit (43) in dem separaten Kanal platziert ist.

16. Gehäuse nach Anspruch 15, wobei die Energieeinheit (43) ihre eigene Lüftereinheit besitzt, wobei beide Lüftereinheiten Luft von der Vorderseite des Gehäuses (22) gemeinsam ansaugen.

17. Gehäuse nach Anspruch 13, wobei auf zumindest einer seitlichen Fläche der Lüftereinheit (11) in dem Gehäuse ein separater Kanal (42) verläuft, in dem Kanal verschiedene elektrische Verbindungskabel verlaufen, wobei der Kabelkanal nicht belüftet ist.

18. Gehäuse nach Anspruch 11, wobei die Lüftereinheit (11) die Aussparung in dem Gehäuse in dem Einführungsbereich vollständig abdichtet.

19. Gehäuse nach Anspruch 1, wobei das Gehäuse (22) im Wesentlichen quaderförmig, flach und in einer Richtung langgestreckt ist, wobei die Aussparung in der langgestreckten Ausdehnung in etwa mittig im Gehäuse angeordnet ist.

20. Gehäuse nach Anspruch 1, wobei die Lüftereinheit (11) in einem Belüftungsweg durch das Gehäuse etwa mittig angeordnet ist, wobei Luft durch die Vorderseite des Gehäuses (22) eingesaugt und durch die Rückseite des Gehäuses ausgeblasen wird.

21. Gehäuse nach Anspruch 20, wobei Plattenlaufwerke (46) im Bereich der von der Lüftereinheit eingesaugten Luft angeordnet sind, und Prozessoren und Elektronik-Leiterplatten im Bereich der Luft angeordnet sind, die von der Lüftereinheit (11) ausgeblasen wird.

22. Gehäuse nach Anspruch 1, wobei das Gehäuse (22) eine Vorderfront aufweist, und der Luftstrom der Lüftereinheit im Wesentlichen von mit der Vorderfront zu der gegenüberliegenden Rückseite des Gehäuses strömt, wobei die Rückseite mit Lüftungsöffnungen versehen ist sowie die rückseitigen Teile der seitlichen Ränder des Gehäuses mit Lüftungsöffnungen versehen sind.

23. Gehäuse nach Anspruch 1, wobei ein Luftstrom durch das Gehäuse (22) durch Lüftungsöffnungen sowie Ablenkungs- und Richtungsplatten gelenkt wird.

24. Gehäuse nach Anspruch 1, wobei das Gehäuse ein Gehäusemodul eines 19"-Einschubmoduls für einen mittleren bis Großrechner ist, wobei die Datenträger und die Plattenlaufwerke sowie die Prozessoren in dem Gehäusemodul enthalten sind.

25. Gehäuse nach Anspruch 1, wobei das Gehäuse (22) eine verriegelbare vordere Klappe aufweist, wobei das Gehäuse mit dieser verriegelbaren vorderen Klappe vollständig mit der Lüftereinheit zusammen verriegelbar ist.

26. Gehäuse nach Anspruch 1, wobei die Energieversorgung des Gehäuses verschiedene einzelne Energieversorgungseinheiten aufweist, die über eine Hauptsammelschiene miteinander verbunden sind, wobei an der Sammelschiene Steckerkupplungen angebracht sind für Komponenten wie Plattenlaufwerke, die an dem Gehäuse angebracht sind.

27. Lüftereinheit zum Einsetzen in ein Gehäuse (22), einer elektronischen Vorrichtung, wobei:
- die Lüftereinheiht (11) zumindest einen Lüfter (12) aufweist, der auf einem Träger angeordnet ist,
- die Lüftereinheit (11) mit dem Träger zumindest größtenteils in eine entsprechende Aussparung (24) in dem Gehäuse einführbar und verriegelbar ist,
- die Lüftereinheit auf dem Träger Vorsprünge besitzt,
- die Lüftereinheit (11) unter den Vorsprüngen Verriegelungen aufweist, um die Lüftereinheit (11) in dem Gehäuse zu verriegeln, wobei die Lüftereinheit nicht lösbar über Mittel der eingeführten Lüftereinheit (11) verriegelt ist.

28. Lüftereinheit nach Anspruch 27, wobei die Lüftereinheit (11) als Einschubmodul ausgebildet ist und mechanisch und elektrisch lösbar von dem Gehäuse ist, wobei es vollständig trennbar von dem Gehäuse ist und eine unabhängige Anordnung bildet.

29. Lüftereinheit nach Anspruch 27, wobei die Lüftereinheit mehrere Lüfterklammern (12) aufweist, die nebeneinander und direkt miteinander verbunden sind, und ferner axial nebeneinander liegen.

30. Lüftereinheit nach Anspruch 27, wobei der Lüfter (12) lösbar an dem Träger befestigt ist, wobei der Träger zur Abdichtung der Aussparung (24) des Gehäuses (22) flach ist.

31. Lüftereinheit nach Anspruch 27, wobei die Lüftereinheit (11) lösbar in dem Gehäuse (22) über Verriegelungsmittel haltbar ist.

## Revendications

1. Boîtier pour un dispositif électronique, ledit boîtier (22) comprenant un ensemble formant ventilateur (11) destiné à produire un écoulement d'air dans ledit boîtier (22) dans lequel :
- ledit boîtier (22) possède un couvercle amovible (23) couvrant la partie supérieure dudit boîtier (22),
- ledit ensemble formant ventilateur (11) est susceptible d'être inséré dans ledit boîtier (22) à partir de l'extérieur dans un évidement (24) ménagé dans ladite partie supérieure et d'être verrouillé dans ledit boîtier, et
- ledit couvercle (23) ne pouvant être retiré que si ledit ensemble formant ventilateur est retiré.

2. Boîtier selon la revendication 1, dans lequel en position insérée dudit ensemble formant ventilateur (11), ledit ensemble formant ventilateur fait saillie largement dans ledit boîtier (22).

3. Boîtier selon la revendication 2, dans lequel ledit ensemble formant ventilateur (11) est placé dans un évidement (24) ménagé à l'intérieur du boîtier.

4. Boîtier selon la revendication 1, dans lequel ledit ensemble formant ventilateur (11) comprend au moins un ventilateur électromoteur (12).

5. Boîtier selon la revendication 4, dans lequel ledit ensemble formant ventilateur (11) comprend au moins deux ventilateurs (12) qui sont juxtaposés dans le sens axial et parallèles.

6. Boîtier selon la revendication 1, dans lequel ledit ensemble formant ventilateur (11) peut être maintenu de manière détachable dans ledit boîtier (22) et est verrouillé à l'aide de moyens de verrouillage (17).

7. Boîtier selon la revendication 6, dans lequel des moyens de verrouillage sont prévus pour ledit ensemble formant ventilateur, lesdits moyens de verrouillage comprenant un bec d'encliquetage sur le boîtier (22) et un logement d'encliquetage (29) sur ledit ensemble formant ventilateur (11).

8. Boîtier selon la revendication 1, dans lequel ledit ensemble formant ventilateur (11), est susceptible d'être retiré et de se séparer entièrement dudit boîtier (22), dans lequel en outre une prise d'alimentation (31) est prévue dans ledit boîtier pour l'alimentation électrique dudit ensemble formant ventilateur, ladite prise de courant comprenant une prise d'alimentation (31) dans le boîtier et une fiche mâle sur l'ensemble formant ventilateur (11).

9. Boîtier selon la revendication 8, dans lequel ladite prise d'alimentation (31) est placée sur une face latérale dudit boîtier au début d'un espace d'insertion dudit ensemble formant ventilateur (11).

10. Boîtier selon la revendication 9, dans lequel ladite prise d'alimentation (31) dans le boîtier (22) laisse une certaine place de mouvement pour une meilleure insertion de ladite prise mâle sur ledit ensemble formant ventilateur.

11. Boîtier selon la revendication 1, dans lequel ledit boîtier (22) à proximité dudit évidement (24) possède un dispositif de guidage pour introduire ledit ensemble formant ventilateur dans ledit boîtier, dans lequel ledit dispositif de guidage comprend un système de rails de guidage fixé audit ensemble formant ventilateur et des logements de guidage (29) fixés audit boîtier.

12. Boîtier selon la revendication 11, dans lequel au moins un ventilateur dudit ensemble formant ventilateur forme sur le bord latéral dudit ensemble formant ventilateur lesdits rails de guidage et à l'intérieur ledit boîtier possède ledit logement de guidage en forme de U correspondant.

13. Boîtier selon la revendication 1, dans lequel ledit ensemble formant ventilateur (11) s'étend sur une partie significative d'au moins une longueur dudit boîtier perpendiculairement au sens d'insertion et à la direction dans le sens axial dudit ensemble formant ventilateur.

14. Boîtier selon la revendication 13, dans lequel ledit ensemble formant ventilateur (11) s'étend dans un plan perpendiculaire au sens axial et occupe plus de la moitié de la section transversale dudit boîtier (22).

15. Boîtier selon la revendication 14, dans lequel sous l'ensemble formant ventilateur (11) une goulotte séparée (38) est ménagée dans ledit boîtier, laquelle est ventilée séparément, dans lequel un ensemble d'alimentation (43) protégé contre les rayonnements électromagnétiques est placé à l'intérieur de ladite goulotte séparée.

16. Boîtier selon la revendication 15, dans lequel ledit ensemble d'alimentation (43) possède son propre ensemble formant ventilateur, dans lequel les deux ensembles formant ventilateur aspirent ensemble l'air par l'avant dudit boîtier (22).

17. Boîtier selon la revendication 13, dans lequel sur au moins un côté latéral dudit ensemble formant ventilateur (11) dans ledit boîtier s'étend une goulotte séparée (42), dans ladite goulotte s'étendent plusieurs câbles électriques de connexion, ladite goulotte pour câbles n'étant pas ventilée.

18. Boîtier selon la revendication 1, dans lequel ledit ensemble formant ventilateur (11) ferme complètement ledit évidement dans ledit boîtier dans la zone d'insertion.

19. Boîtier selon la revendication 1, dans lequel ledit boîtier (22) présente sensiblement la forme d'un parallélépipède, plat et allongé dans un sens, ledit évidement étant positionné dans le sens de la longueur en gros au centre dudit boîtier.

20. Boîtier selon la revendication 1, dans lequel ledit élément formant ventilateur (11) est positionné en gros de manière centrée dans un espace de ventilation ménagé dans ledit boîtier, l'air étant aspiré par l'avant dudit boîtier (22) et refoulé par l'arrière dudit boîtier.

21. Boîtier selon la revendication 20, dans lequel des unités de disques (46) sont positionnées dans la zone d'aspiration de l'air par ledit ensemble formant ventilateur et des processeurs et des cartes de circuits imprimés sont positionnées dans la zone de refoulement de l'air par ledit ensemble formant ventilateur (11).

22. Boîtier selon la revendication 1, dans lequel ledit boîtier (22) comprend un panneau avant et l'écoulement d'air de l'ensemble formant ventilateur s'effectue sensiblement à partir dudit panneau avant en direction de la partie arrière opposée dudit boîtier, ladite partie arrière étant munie d'ouvertures d'air et les parties arrière des bords latéraux dudit boîtier sont également munies d'ouvertures d'aération.

23. Boîtier selon la revendication 1, dans lequel un écoulement d'air à travers ledit boîtier (22) est dirigé par des ouvertures d'aération, ainsi que par des plaques de déflexion ou d'orientation.

24. Boîtier selon la revendication 1, dans lequel ledit boîtier est un module formant boîtier d'un module de 19" inséré par glissière pour ordinateur de taille moyenne à grande, dans lequel les supports de données et les unités de disques, ainsi que les processeurs, sont placés dans ledit module formant boîtier.

25. Boîtier selon la revendication 1, dans lequel boîtier (22) comprend un obturateur avant verrouillable, dans lequel ledit boîtier ainsi que ledit ensemble formant ventilateur peuvent être entièrement verrouillés à l'aide de l'obturateur avant verrouillable.

26. Boîtier selon la revendication 1, dans lequel l'alimentation électrique dudit boîtier comprend plusieurs postes d'alimentation simples reliées ensemble par une barre bus principale, des fiches sont montées sur ladite barre bus pour des composants tels que les unités de disques montées dans ledit boîtier.

27. Ensemble formant ventilateur à insérer dans un boîtier (22) destiné à un dispositif électronique, dans lequel :
- ledit ensemble formant ventilateur (11) comprend au moins un ventilateur (12) placé sur un support,
- ledit ensemble formant ventilateur (11) sur ledit support peut largement être inséré et verrouillé dans un évidement (24) correspondant à l'intérieur dudit boîtier,
- ledit ensemble formant ventilateur est muni de projections sur ledit support,
- sous lesdites projections ledit ensemble formant ventilateur (11) comprend des cliquets pour verrouiller l'unité formant ventilateur (11) dans le boîtier, l'ensemble formant ventilateur pouvant ainsi être verrouillé en vue de son retrait au moyen de l'ensemble formant ventilateur (11).

28. Ensemble formant ventilateur selon la revendication 27, dans lequel ledit ensemble formant ventilateur (11) est construit sous la forme d'un module inséré par glissière et peut être séparé mécaniquement et électriquement dudit boîtier, lequel forme un ensemble indépendant une fois complètement retiré dudit boîtier.

29. Ensemble formant ventilateur selon la revendication 27, dans lequel ledit ensemble formant ventilateur comprend plusieurs ventilateurs (12) juxtaposés et directement reliés l'un à l'autre, lesquels sont en outre juxtaposés dans le sens axial.

30. Ensemble formant ventilateur selon la revendication 27, dans lequel ledit ventilateur (12) est fixé en vue de son retrait audit support, ledit support étant plat pour fermer hermétiquement ledit évidement (24) dudit boîtier (22).

31. Ensemble formant ventilateur selon la revendication 27, dans lequel ledit ensemble formant ventilateur (11) peut être maintenu de manière détachable dans ledit boîtier (22) par des moyens de verrouillage.
